# EUROPEAN PATENT SPECIFICATION

(11) **EP 2 068 402 B1**
(45) Date of publication and mention of the grant of the patent: **20.01.2010**
(21) Application number: 07425685.0
(22) Date of filing: 30.10.2007
(51) Int. Cl.: H01R 11/28, G01R 31/36, H01M 10/48, G01R 1/20

(54) **A device for measuring the current of a battery on board of a motor-vehicle and a method for assembling the device**
Vorrichtung zum Erfassen des Stroms einer Fahrzeugsbatterie und Zusammenbauverfahren dieser Vorrichtung
Un dispositif pour mesurer in-situ le courant d'une batterie d'un véhicule à moteur et une méthode d'assemblage du dispositif

(43) Date of publication of application: 10.06.2009
(73) Proprietor: Magneti Marelli S.p.A., 20011 Corbetta (MI) (IT)
(72) Inventor: Nepote, Andrea, 10078 Venaria Reale (Torino) (IT); Giraudo, Gabriele, 10078 Venaria Reale (Torino) (IT)
(74) Representative: Notaro, Giancarlo

(56) References cited:
- WO-A-2006/119953
- DE-A1-102006 036 247
- FR-A- 2 866 158

## Description

The present invention relates to devices for measuring the current of a battery on board a motor vehicle, of the type indicated in the precharacterizing portion of claim 1. A device of this type is shown in FR-A-2 866 158. A battery current sensor in form of a cylindrical bar having its opposite ends fitted within connecting sleeves is known from WO-A-2006/119953.

The general technical problem underlying the use of devices of the type referred to above is to measure the state of charge (SOC) of a battery on board a motor vehicle, as well as to assess the state of health (SOH) thereof and the state of function (SOF), i.e., how far it is able to perform its task properly, in particular starting of the engine of the motor vehicle.

Said measurements imply the measurement of the voltage across the poles of the battery, the temperature, and the current supplied and absorbed by the battery. Determination of the voltage does not involve any particular problems. Determination of the temperature is carried out in any suitable way, for example using thermocouples or thermistors or detection circuits. The problem of the measurement of the current does not, instead, have an immediate solution, for the reasons given hereinafter.

The range of variability of the battery current is extremely wide, measurement thereof being required in various steps of operation of the vehicle. There may, for example, be required a measurement of a maximum of 1 A with an accepted noise level of 10 mAₚₚ (for example, with the ignition key in the ON position and the engine turned off) up to 1,500 A, during starting of the engine. The high current requirement imposes the need to use a very low resistance, typically of the order of 100 µΩ so as to contain the dissipation of power (225 W for a few seconds, in the example considered). On the other hand, the use of such a low resistive value poses problems of signal-to-noise ratio on the voltage values detected across the resistance, as well as of sensitivity of the electronics for conditioning and conversion of the signal. By way of example, a noise level of 10 mAₚₚ on a resistance of 100 µΩ is equivalent to a voltage signal of 1µV.

Added to the aforesaid problems is the need of the value detected to be independent of the temperature, which is subject to wide variations, in particular in the (usual) case where the battery is housed in the engine compartment of the motor vehicle. The solution adopted in more conventional devices consists in making the shunt functioning as sensing element with a material the electrical resistance of which presents an extremely small variation in the required temperature range, such as for example Manganin.

Illustrated in the document No. DE 10 2004 042 719 A1 is a solution in which, instead, the sensing element is made of copper and in which there is moreover provided an electronics designed to correct the detected current value to take into account the variation of resistance of the shunt as the temperature varies. A solution of this type, in which, however, a new and advantageous methodology of compensation of the detected current value is used as the temperature varies, has formed the subject of a co-pending European patent application filed in the name of the present applicant (EP 07 425 603.3).

The present invention relates to devices for measuring the battery current both of the type using a shunt made of a material such as Manganin, the resistivity of which is relatively indifferent to temperature variations, and of the type in which the shunt is made of a material the resistivity of which varies significantly as the temperature varies and for which there is hence provided a circuit for compensation of the detected current value as the temperature varies.

The purpose of the invention is to provide a device of this type that will present a structure that is extremely simple, light, and easy and fast to assemble.

With a view to achieving said purpose, the subject of the invention is a device as specified in the annexed Claim 1 and an assembly method as specified in Claim 8. Further characteristics of some advantageous embodiments of the invention form the subject of the annexed dependent claims.

The invention will now be described with reference to the annexed plates of drawings, which are provided purely by way of non-limiting example and in which:
- Figure 1 is a schematic cross-sectional view of a device according to a first embodiment which does not form part of the invention; and
- Figures 2-6 illustrate different embodiments not forming part of the invention, and
- Figures 7-10 illustrate different embodiments of the device and of the method according to the invention.

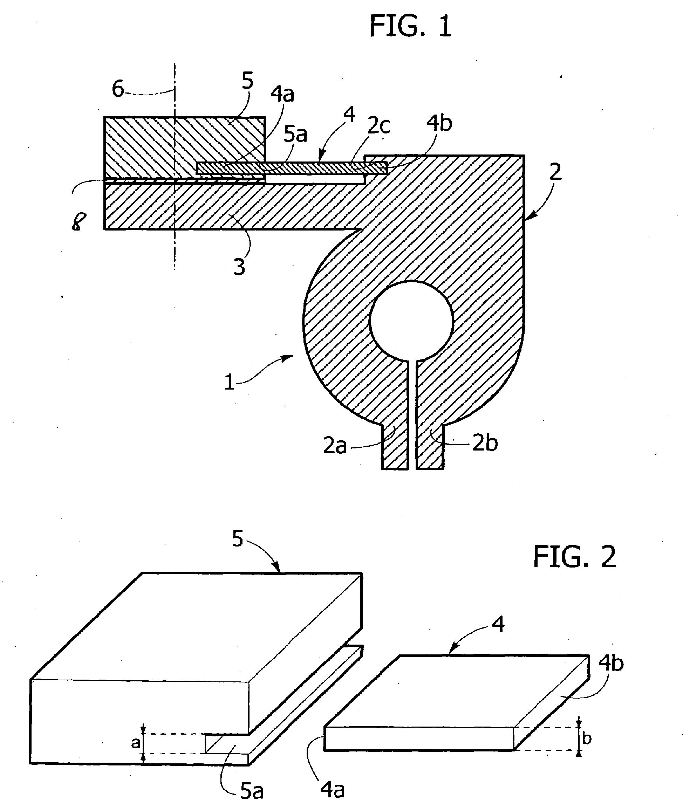

With reference to Figure 1, the number 1 indicates as a whole a terminal of a motor-vehicle battery comprising a body 2, in itself of a known type, made for example of brass, having two elastically deformable terminal arms 2a, 2b for gripping together a terminal of the battery, and a base plate 3. The reference number 4 designates as a whole an element for detecting the battery current, or shunt, constituted by a plate, which in the example illustrated is made of a material having a resistivity that is substantially indifferent to temperature variations, such as for example Manganin. The plate 4 constituting the shunt has an end 4a connected directly to a bar 5, made of copper, which is in turn designed to be connected to a conductive cable (not illustrated). The copper bar 5 is fixed to the base portion 3 of the terminal 2 by means of screws (visible in Figure 1 is just one axis 6 of one of said screws). In the case of the example illustrated, set between the bar 5 and the portion 3 of the terminal 2 is a layer of insulating material 8.

The shunt 4 is designed to be connected to an electronic detection unit (not illustrated), designed to gather and process the data regarding the voltage across the shunt 4, at the temperature and at the value of the current that traverses it.

In the case of the example illustrated in Figure 1, the first end 4a of the plate constituting the shunt 4 is fixed within a groove 5a of the bar 5. Likewise, a second end 4b of the plate 4 is fixed within a groove 2c of the body 2 of the terminal 1.

A fundamental characteristic of the device and of the method according to the invention lies in the fact that the first end 4a of the plate 4 constituting the shunt is connected directly to the bar 5 only by means of a mechanical connection, without welding. According to a first embodiment not forming part of the invention, illustrated in Figure 2, the end 4a of the shunt 4 is fixed with an interference fit within the groove 5a. This means that the groove 5a is made in the bar 5 with a height *a* (Figure 2) that is slightly smaller than the height *b* of the plate 4 constituting the shunt.

In one example of embodiment, not forming part of the invention, the aforesaid interference fit is obtained by inserting the plate 4 within the groove 5a after having obtained an increase in the height of the groove 5a by means of a step of heating of the bar 5 so as to clamp the plate 4 within the groove following upon subsequent cooling of the bar.

In the case of said embodiment, a further advantage can be obtained by making the plate 4 with a material having a coefficient of thermal expansion higher than that of the material constituting the bar 5, in such a way that the interference between the plate 4 and the groove 5a of the bar 5 increases as the temperature rises during use of the motor vehicle. Said increase in temperature may be considerable above all in the case
where the battery of the motor vehicle is housed, as is frequently the case, in the engine compartment.

It should be pointed out, however, that it is altogether possible, to use for the plate 4 a material, such as for example Manganin, that has a coefficient of thermal expansion that is not higher than that of the copper constituting the bar 5 (Manganin has a coefficient of thermal expansion of 14·10⁻⁶K⁻¹, whilst the coefficient of copper is 16.5·10⁻⁶K⁻¹). The percentage of thermal expansion of copper at 1000°C is 16.5.10⁻³, i.e., approximately 1.65%. This means that, if the groove 5a has a height *a* of the order of a millimetre, the expansion is of the order of one hundredth of a millimetre, a value that is compatible with the precision of the machining operations currently performed and enables in any case a guarantee of the stability of the connection, notwithstanding the lower expansion of the Manganin constituting the plate 4.

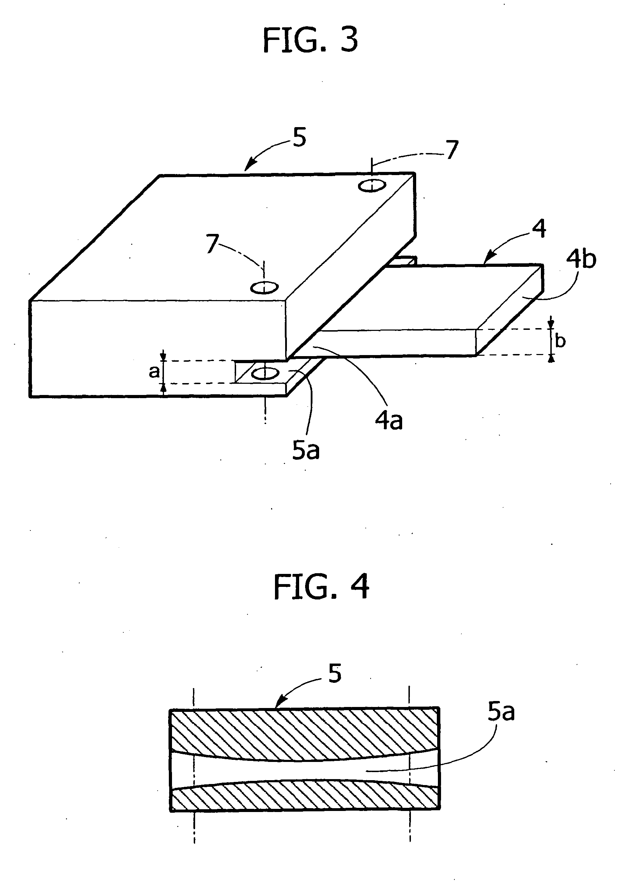

Figures 3 and 4 illustrate an alternative solution, not forming part of the invention, in which the end 4a of the plate 4 constituting the shunt is once again received within a groove 5a of the bar 5, but the assembly is not by interference fit, the height *b* of the plate 4 being slightly smaller than the height *a* of the groove 5a. In this case, subsequent to insertion of the plate 4 within the groove 5a, the end 4a is gripped within the groove by permanent deformation of the two opposed faces of the groove against one another. Said deformation can be obtained, for example, by means of screws inserted along the axes designated by 7. Illustrated with proportions exaggerated for reasons of clarity in Figure 4 is a particular embodiment of the two opposed faces of the groove 5a designed to optimize the connection between the bar 5 and the plate 4.

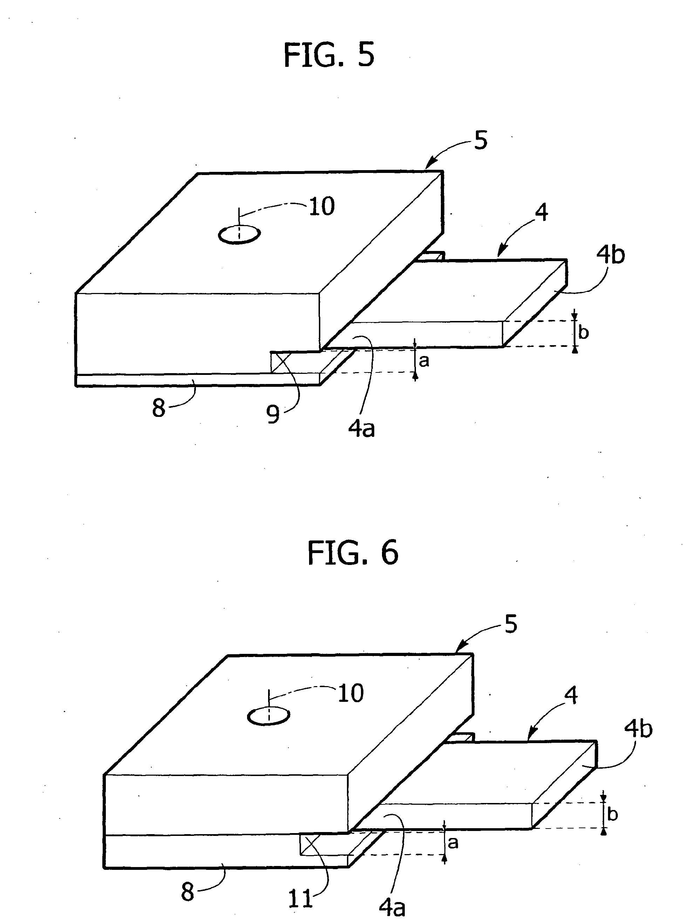

Figures 5, 6 illustrate a further variant, not forming part of the invention, in which the end 4a of the plate 4 constituting the shunt is gripped between the bar 5 and an auxiliary element 8 in the form of a plane plate, made of conductive or insulating material, according to the need. In the case of Figure 5, the auxiliary plate 8 is flat and co-operates with a steplike cavity 9 made in the bar 5 to define the groove that receives the plate 4. The height of the steplike cavity 9, designated by *a* is slightly smaller than the height *b* of the plate 4, in such a way that gripping of the auxiliary plate 8 to the bar 5, which is obtained for example by means of one or more screws of axis 10, causes gripping of the plate 4 between the aforesaid elements.

Figure 6 illustrates a variant in which the steplike cavity, designated by 11, is made in the auxiliary plate 8, whilst the bar 5 has a plane surface co-operating with the cavity 11 to define the groove that receives the plate 4.

With reference once again to Figure 1, the end 4b of the plate 4 that is received within the groove 2c of the body 2 of the terminal 1 is also preferably connected directly to the terminal by means of a simple mechanical fit, without welding. Said fit can be obtained by means of simple interference or else, more conveniently, with any of the techniques described above in relation to the end 4a of the plate 4 with reference to Figures 2, 3, 4, 5 and 6.

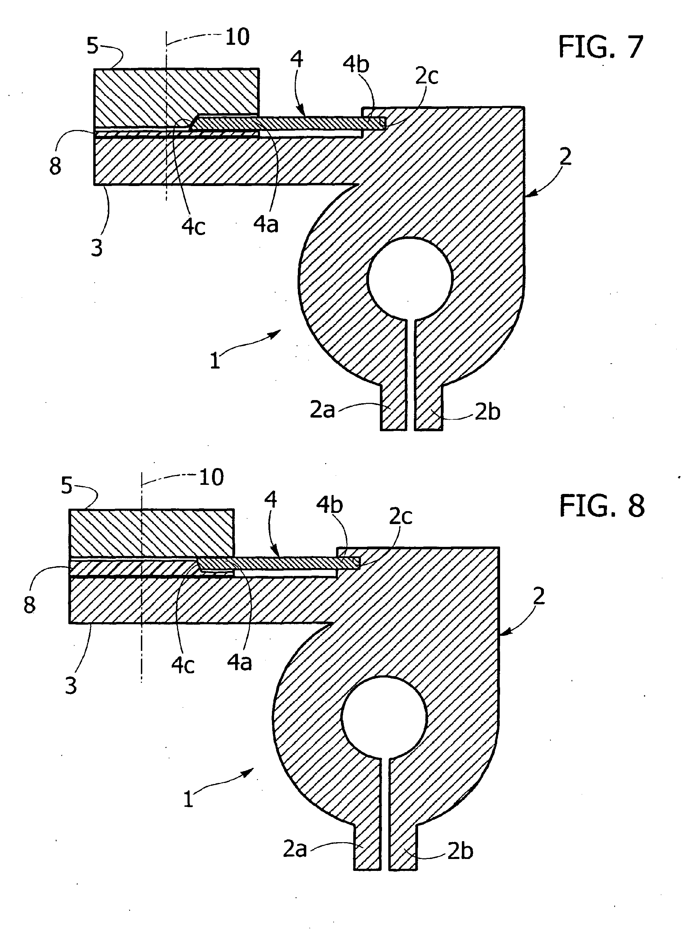

In a preferred solution, illustrated in Figure 7, the plate 4 has, at its first end 4a, an inclined head surface 4c, which co-operates with a corresponding inclined surface of the steplike cavity 9 of the bar 5. In the case of Figure 7, as in that of Figure 5, the end 4a of the plate 4 is gripped between the bar 5 and an auxiliary plate 8, by means of screws of axis 10 that grip said elements to the base portion 3 of the body of the terminal. In the case of Figure 7, the plate 5 (which is illustrated in said figure in a condition prior to execution of gripping) is pressed at the bottom downwards, against the auxiliary plate 8 and the base portion 3 of the terminal, by means of the screws of axis 10. Said downward movement causes, as a consequence of the fitting of the inclined surfaces, not only gripping of the end 4a of the plate 4 between the bar 5 and the auxiliary plate 8, but also a thrust towards the right (as viewed in the figure) of the plate 4, which causes a forcing of the end 4b within the groove 2c, with an interference fit.

Figure 8 illustrates a solution similar to that of Figure 7, which differs from the latter only in that therein, in a way similar to what is illustrated in Figure 6, the groove that receives the end 4a of the plate 4 is made between a plane surface of the bar 5 and a steplike cavity of the auxiliary plate 8. Also in this case, as in the case of Figure 7, the plate 4 has an inclined head surface 4c, which co-operates with a corresponding inclined surface of the auxiliary plate 8. In Figure 8, the ensemble is illustrated in a condition prior to gripping of the bar 5 against the auxiliary plate 8 and the base portion 3 in such a way as to obtain, in addition to gripping of the end 4a between the bar 5 and the auxiliary plate 8, also a thrust towards the right (as viewed in the figure) of the plate 8, which increases forcing of the end 4b within the groove 2c.

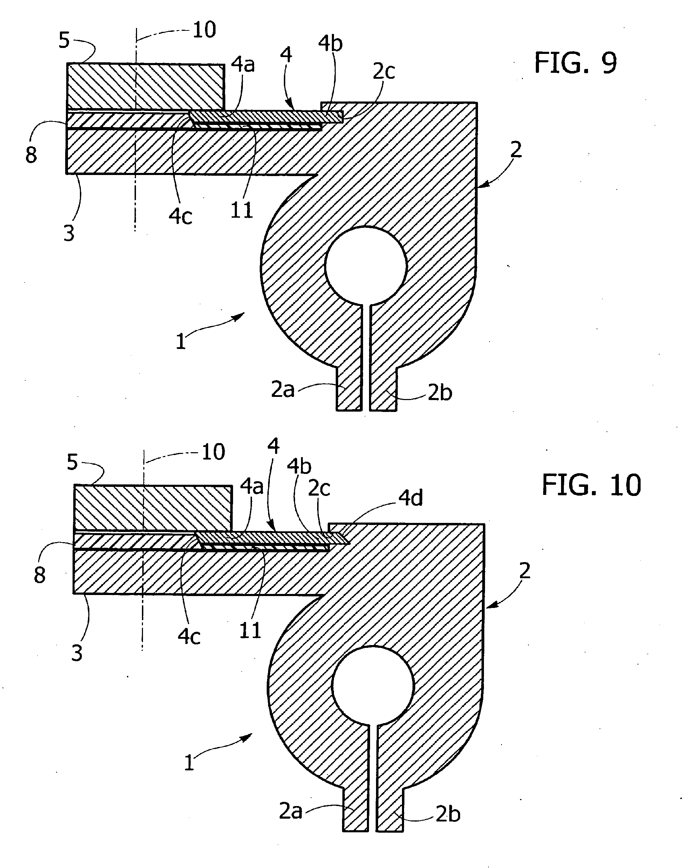

Figure 9 is a view corresponding to that of Figure 8, which differs from the latter in so far as the auxiliary plate 8 does not extend underneath the plate 4 constituting the shunt, the space that separates the plate 4 from the portion 3 being filled with a layer 11 of thermally conductive material. Of course, the layer 11 can on the other hand be provided also in the embodiments represented in Figures 1, 7 and 8.

The embodiment illustrated in Figure 10 differs from that of Figure 9 only in so far as in this case the end 4b of the plate 4 also has an inclined head surface 4d, which improves contact with the body of the terminal.

In all of the variants illustrated above, there can be provided conductive paste or powder in a position corresponding to the connection of one or both of the ends 4a, 4b of the plate 4 constituting the shunt.

## Claims

1. A device for measuring the current of a battery on board a motor vehicle, comprising a resistor or shunt, constituted by a plate (4) of electrically conductive material connected in series between a body (2) defining a terminal (1) of the battery and a bar (5) that can be connected to a conductive cable,
wherein said plate (4) constituting the sensor element has a first end (4a) connected directly to said bar (5) only by means of a mechanical connection, without welding, and a second end (4b), opposite to said first end (4a), which is also connected directly to the body (2) of the terminal (1) only by means of a mechanical connection, without welding,
said device being **characterized in that**:
- said second end (4b) of the plate (4) is interference-fitted within a groove (2c) of the body (2) of the terminal (1), and
- the first end (4a) of the plate (4) constituting the sensor element or shunt is gripped by screw-connection means (10) between said bar (5) and an auxiliary element (8), and **in that** said first end (4a) of the plate (4) has an inclined head surface (4c), co-operating with an inclined surface of said bar (5) or of said auxiliary element (8), in such a way that gripping of the plate (4) between the bar (5) and the auxiliary element (8) by said screw-connection means (10) pushes the plate (4) within the groove (2c) of the body (2) of the terminal (1).

2. The device according to Claim 1, **characterized in that** said auxiliary element is an auxiliary plate juxtaposed with the bar (5) and defining therewith a groove (5a), within which the plate constituting the sensor element or shunt is gripped.

3. The device according to Claim 2, **characterized in that** said auxiliary plate (8) is substantially flat and co-operates with a steplike cavity (9) formed in said bar (5) to define said groove (5a).

4. The device according to Claim 2, **characterized in that** said auxiliary plate (8) has a steplike cavity (11), which co-operates with a plane surface of said bar (5) to define said groove (5a).

5. The device according to Claim 1, **characterized in that** said second end (4b) of the plate (4) that is received within the groove (2c) of the body (2) of the terminal (1) has an inclined head surface (4d) co-operating with an inclined surface of the groove (2c).

6. The device according to any one of the preceding claims, **characterized in that** in the connections of one or both of the ends (4a,4b) of said plate (4) constituting the resistive element or shunt is interposed a conductive powder or paste.

7. The device according to any one of the preceding claims, **characterized in that** set between said shunt (4) and the body (3) of the terminal is a layer (11) of thermally conductive material.

8. A method for assembling a device for measuring the current of a battery on board a motor vehicle, in which said device comprises a resistor or shunt, constituted by a plate (4) made of electrically conductive material connected in series between a body (2) defining a terminal (1) of the battery and a bar (5) that can be connected to a conductive cable,
wherein a first end (4a) of the plate (4) constituting the sensor element is connected directly to said bar (5) only by means of a mechanical connection, without welding, and a second end (4b) of said plate (4) opposite to said first end (4a) is connected directly to the body (2) of the terminal (1) only by means of a mechanical connection, without welding, said method being **characterized in that**:
- the first end (4a) of the plate (4) constituting the sensor element or shunt is gripped by screw-connection means (10) between said bar (5) and an auxiliary element (8), and **in that** said first end (4a) of the plate (4) has an inclined head surface (4c), co-operating with an inclined surface of said bar (5) or of said auxiliary element (8) in such a way that gripping of the plate (4) by said screw connection means (10) between the bar (5) and the auxiliary element (8) pushes the plate (4) within the groove (2c) of the body (2) of the terminal (1).

9. The method according to Claim 8, **characterized in that** said second end (4b) of the plate (4) that is received within the groove (2c) of the body (2) of the terminal (1) has an inclined head surface (4d) co-operating with an inclined surface of the groove (2c).

## Patentansprüche

1. Vorrichtung zum Erfassen des Stroms einer Fahrzeugbatterie umfassend einen Widerstand oder Shunt, der durch eine Platte (4) aus elektrisch leitfähigem Material gebildet ist, welches in Serie zwischen einem Körper (2), der einen Anschluss (1) der Batterie bildet, und einer Stange (5) verbunden ist, welche mit einem leitfähigen Kabel verbunden werden kann,
wobei die das Sensorelement bildende Platte (4) ein erstes Ende (4a) aufweist, welches nur mittels einer mechanischen Verbindung direkt mit der Stange (5) verbunden ist, ohne Schweißen, und ein zweites Ende (4b) aufweist, gegenüber dem ersten Ende (4a), welches ebenso nur mittels einer mechanischen Verbindung direkt mit dem Körper (2) des Anschlusses (1) verbunden ist, ohne Schweißen,
wobei die Vorrichtung **dadurch gekennzeichnet, dass:**
- das zweite Ende (4b) der Platte (4) innerhalb einer Nut (2c) des Körpers (2) des Anschlusses (1) pressgepasst ist, und
- das erste Ende (4a) der das Sensorelement oder den Shunt bildenden Platte (4) mittels Schraubverbindungsmitteln (10) zwischen der Stange (5) und einem Zusatzelement (8) eingefasst ist, und **dadurch**, dass das erste Ende (4a) der Platte (4) eine geneigte Kopfoberfläche (4c) aufweist, die mit einer geneigten Oberfläche der Stange (5) oder des Zusatzelements (8) derart zusammenwirkt, dass ein Einfassen der Platte (4) zwischen der Stange (5) und dem Zusatzelement (8) mittels Schraubverbindungsmitteln (10) die Platte (4) in die Nut (2c) des Körpers (2) des Anschlusses (1) drückt.

2. Vorrichtung nach Anspruch 1, **dadurch gekennzeichnet, dass** das Zusatzelement eine Zusatzplatte neben der Stange (5) ist und damit eine Nut (5a) definiert, innerhalb welcher die das Sensorelement oder den Shunt bildende Platte eingefasst ist.

3. Vorrichtung nach Anspruch 2, **dadurch gekennzeichnet, dass** die Zusatzplatte (8) im Wesentlichen flach ist und mit einer stufenförmigen Aussparung (9) zusammenwirkt, die in der Stange (5) gebildet ist, um die Nut (5a) zu definieren.

4. Vorrichtung nach Anspruch 2, **dadurch gekennzeichnet, dass** die Zusatzplatte (8) eine stufenförmige Aussparung (11) aufweist, welche mit einer ebenen Oberfläche der Stange (5) zusammenwirkt, um die Nut (5a) zu definieren.

5. Vorrichtung nach Anspruch 1, **dadurch gekennzeichnet, dass** das zweite Ende (4b) der Platte (4), die innerhalb der Nut (2c) des Körpers (2) des Anschlusses (1) aufgenommen ist, eine geneigte Kopfoberfläche (4d) aufweist, die mit einer geneigten Oberfläche der Nut (2c) zusammenwirkt.

6. Vorrichtung nach irgendeinem der vorhergehenden Ansprüche, **dadurch gekennzeichnet, dass** die Verbindungen von einem oder beiden Enden (4a, 4b) der Platte 4, die das Widerstandselement oder den Shunt bilden, in ein leitfähiges Pulver oder eine Paste eingesetzt ist.

7. Vorrichtung nach irgendeinem der vorhergehenden Ansprüche, **dadurch gekennzeichnet, dass** zwischen den Shunt (4) und den Körper (3) des Anschlusses eine Schicht (11) aus thermisch leitfähigem Material eingesetzt ist.

8. Verfahren zum Zusammenbau einer Vorrichtung zum Erfassen des Stroms einer Fahrzeugbatterie, in welchem die Vorrichtung einen Widerstand oder Shunt umfasst, der durch eine Platte (4) aus elektrisch leitfähigem Material gebildet ist, welches in Serie zwischen einem Körper (2), welcher einen Anschluss (1) der Batterie bildet, und einer Stange (5), die mit einem leitfähigen Kabel verbunden werden kann, verbunden ist,
wobei ein erstes Ende (4a) der Platte (4), welche das Sensorelement bildet, nur mittels einer mechanischen Verbindung direkt mit der Platte (4) verbunden ist, welche das Sensorelement bildet, ohne Verschweißen, und ein zweites Ende (4b) der Platte (4) gegenüber dem ersten Ende (4a) nur mittels einer mechanischen Verbindung direkt mit dem Körper (2) des Anschlusses (1) verbunden ist, ohne Verschweißen,
wobei das Verfahren **dadurch gekennzeichnet ist, dass**:
- das erste Ende (4a) der Platte (4), die das Sensorelement oder den Shunt bildet, durch Schraubverbindungsmittel (10) zwischen der Stange (5) und einem Zusatzelement (8) eingefasst ist, und **dadurch**, dass das erste Ende (4a) der Platte (4) eine geneigte Kopfoberfläche (4c) aufweist, die mit einer geneigten Oberfläche der Stange (5) oder des Zusatzelements (8) derart zusammenwirkt, dass ein Einfassen der Platte (4) durch die Schraubverbindungsmittel (10) zwischen der Stange (5) und dem Zusatzelement (8) die Platte in die Nut (2c) des Körpers (2) des Anschlusses (1) drückt.

9. Verfahren nach Anspruch 8, **dadurch gekennzeichnet, dass** das zweite Ende (4b) der Platte (4), die innerhalb der Nut (2c) des Körpers (2) des Anschlusses (1) aufgenommen ist, eine geneigte Kopfoberfläche (4d) aufweist, die mit einer geneigten Oberfläche der Nut (2c) zusammenwirkt.

## Revendications

1. Un dispositif pour mesurer le courant d'une batterie à bord d'un véhicule automobile, comprenant une résistance ou un shunt, constitué d'une plaque (4) de matériau électriquement conducteur montée en série entre un corps (2) définissant une borne (1) de la batterie et une barre (5) qui peut être reliée à un câble conducteur,
dans lequel ladite plaque (4) constituant l'élément capteur possède une première extrémité (4a) reliée directement à ladite barre (5) uniquement au moyen d'une liaison mécanique, sans soudure, et une seconde extrémité (4b), opposée à ladite première extrémité (4a), qui est également reliée directement au corps (2) de la borne (1) uniquement au moyen d'une liaison mécanique, sans soudure, ledit dispositif étant **caractérisé en ce que :**
- ladite seconde extrémité (4b) de la plaque (4) est disposée avec ajustement serré à l'intérieur d'une gorge (2c) du corps (2) de la borne (1), et
- la première extrémité (4a) de la plaque (4) constituant l'élément capteur ou le shunt est pincée par des moyens de liaison à vis (10) entre ladite barre (5) et un élément auxiliaire (8), et **en ce que** ladite première extrémité (4a) de la plaque (4) a une surface de tête inclinée (4c), coopérant avec une surface inclinée de ladite barre (5) ou dudit élément auxiliaire (8), d'une manière telle que le pincement de la plaque (4) entre la barre (5) et l'élément auxiliaire (8) par lesdits moyens de liaison à vis (10) pousse la plaque (4) à l'intérieur de la gorge (2c) du corps (2) de la borne (1).

2. Dispositif selon la revendication 1, **caractérisé en ce que** ledit élément auxiliaire est une plaque auxiliaire juxtaposée avec la barre (5) et définissant avec celle-ci une gorge (5a), à l'intérieur de laquelle est pincée la plaque constituant l'élément capteur ou le shunt.

3. Le dispositif selon la revendication 2, **caractérisé en ce que** ladite plaque auxiliaire (8) est substantiellement plane et coopère avec une cavité comparable à une marche (9) formée dans ladite barre pour définir ladite gorge (5a).

4. Le dispositif selon la revendication 2, **caractérisé en ce que** ladite plaque auxiliaire (8) possède une cavité comparable à une marche (11) qui coopère avec une surface plane de ladite barre (5) pour définir ladite gorge (5a).

5. Le dispositif selon la revendication 1, **caractérisé en ce que** la seconde extrémité (4b) de la plaque (4) qui est reçue à l'intérieur de la gorge (2c) du corps (2) de la borne (1) possède une surface de tête inclinée (4d) coopérant avec la surface inclinée de la gorge (2c).

6. Le dispositif selon l'une des revendications précédentes, **caractérisé en ce qu'**une poudre ou pâte conductrice est interposée dans les liaisons de l'une ou des deux extrémités (4a, 4b) de ladite plaque (4) constituant l'élément résistif ou le shunt.

7. Le dispositif selon l'une des revendications précédentes, **caractérisé en ce qu'**une couche (11) de matériau thermiquement conducteur est disposée entre ledit shunt (4) et le corps (3) de la borne.

8. Un procédé pour assembler un dispositif pour mesurer le courant d'une batterie à bord d'un véhicule automobile, dans lequel ledit dispositif comprend une résistance ou un shunt, constitué d'une plaque (4) de matériau électriquement conducteur montée en série entre un corps (2) définissant une borne (1) de la batterie et une barre (5) qui peut être reliée à un câble conducteur, dans lequel une première extrémité (4a) de la plaque (4) constituant l'élément capteur possède est reliée directement à ladite barre (5) uniquement au moyen d'une liaison mécanique, sans soudure, et une seconde extrémité (4b) de ladite plaque (4) opposée à ladite première extrémité (4a) est reliée au corps (2) de la borne (1) uniquement au moyen d'une liaison mécanique, sans soudure, ledit procédé étant **caractérisé en ce que** :
- la première extrémité (4a) de la plaque (4) constituant l'élément capteur ou le shunt est pincée par des moyens de liaison à vis (10) entre ladite barre (5) et un élément auxiliaire (8), et **en ce que** ladite première extrémité (4a) de la plaque (4) a une surface de tête inclinée (4c), coopérant avec une surface inclinée de ladite barre (5) ou dudit élément auxiliaire (8) d'une manière telle que le pincement de la plaque (4) par lesdits moyens de liaison à vis (10) entre la barre (5) et l'élément auxiliaire (8) pousse la plaque (4) à l'intérieur de la gorge (2c) du corps (2) de la borne (1).

9. Le procédé selon la revendication 8, **caractérisé en ce que** la seconde extrémité (4b) de la plaque (4) qui est reçue à l'intérieur de la gorge (2c) du corps (2) de la borne (1) possède une surface de tête inclinée (4d) coopérant avec la surface inclinée de la gorge (2c).
